# FASCICULE DE BREVET EUROPEEN

(11) **EP 0 660 333 B1**
(45) Date de publication et mention de la délivrance du brevet: **21.08.1996**
(21) Numéro de dépôt: 94402912.3
(22) Date de dépôt: 16.12.1994
(51) Int. Cl.: G11C 16/06, G11C 7/00

(54) **Mémoire en circuit intégré à temps de lecture amélioré**
Integrierte Speicherschaltung mit verbesserter Lesezeit
Integrated circuit memory with improved reading time

(30) Priorité: 22.12.1993 FR 9315499
(43) Date de publication de la demande: 28.06.1995
(73) Titulaire: SGS-THOMSON MICROELECTRONICS S.A., F-94250 Gentilly (FR)
(72) Inventeur: Devin, Jean, Cabinet Ballot-Schmit, F-75116 Paris (FR)
(74) Mandataire: Schmit, Christian Norbert Marie

(56) Documents cités:
- EP-A- 0 107 415
- EP-A- 0 313 431
- EP-A- 0 421 839
- ELECTRONICS., vol.56, no.24, 1 Décembre 1983, NEW YORK US pages 118 - 121 MEHROTRA ET AL 'Oxynitride film yields long-lived 64-K EE-PROM cells'
- IEEE JOURNAL OF SOLID-STATE CIRCUITS., vol.24, no.5, Octobre 1989, NEW YORK US pages 1250 - 1258 HOFF ET AL 'A 23ns 256K EEPROM with double layer metal and address transition detection'
- IEEE JOURNAL OF SOLID-STATE CIRCUITS., vol.25, no.5, Octobre 1990, NEW YORK US pages 1141 - 1146 KURIYAMA ET AL 'A 16-ns 1-Mb CMOS EEPROM'
- PATENT ABSTRACTS OF JAPAN vol. 12, no. 16 (P-656) 19 Janvier 1988 & JP-A-62 172 595 (MITSUBISHI ELECTRIC CORP.) 29 Juillet 1987
- PATENT ABSTRACTS OF JAPAN vol. 12, no. 16 (P-656) 19 Janvier 1988 & JP-A-62 172 595

## Description

La présente invention a pour objet une mémoire à accès aléatoire en circuit intégré dont le cycle de lecture est accéléré. Cette accélération est due à une nouvelle organisation des opérations de lecture. Le même principe peut par ailleurs être appliqué à l'écriture. L'invention trouve plus particulièrement son application dans le domaine des mémoires de type EPROM, ou dans le domaine des mémoires de type EEPROM, dans lesquels une cellule ou point mémoire possède un transistor à grille flottante comme organe de mémorisation. Parmi ces domaines, elle est encore plus indiquée pour les mémoires de type EPROM Flash.

Les mémoires EPROM sont des mémoires non volatiles dont l'écriture est électrique, point par point, mais dont l'effacement est global: par ultraviolets. Les mémoires EEPROM sont également des mémoires non volatiles, mais dont l'écriture et l'effacement sont électriques. L'effacement est cependant effectué par bloc de points mémoires. Les mémoires EPROM Flash sont des mémoires non volatiles dont l'écriture et l'effacement sont électriques avec des contraintes particulières d'utilisation néanmoins. Pour ces dernières, l'apport de l'invention sera encore plus intéressant car, outre l'accélération de lecture obtenue, elle limite les effets de ces contraintes.

Les points mémoires d'une mémoire sont organisés d'une manière matricielle aux intersections de lignes et de colonnes : les lignes sont dites les lignes de bits, les colonnes sont des lignes de mots. Pour accéder à l'information qui est contenue dans un point mémoire, on sélectionne au moyen de décodeurs une ligne de bits et une ligne de mots caractéristiques du point mémoire à lire. La sélection d'un point mémoire a pour objet de le relier à un circuit de détection, généralement un circuit de détection en courant (dit SENSE dans la littérature anglo-saxonne). Le point mémoire constitué par le transistor à grille flottante se comporte alors, selon son état de programmation, comme une résistance de faible valeur ou comme un circuit ouvert. S'il est une résistance, la ligne de bits auquel il appartient est, au moment de la sélection, reliée à la masse du circuit de la mémoire. Dans ces conditions un courant de décharge peut circuler sur la ligne de bits. Par contre, s'il est un circuit ouvert, une tension préalablement appliquée sur la ligne de bits se conserve. Un détecteur de courant détecte ou ne détecte pas le passage de courant de décharge. En conséquence on a ainsi transformé un état électrique statique, l'état électrique programmé dans le point mémoire, en un état électrique dynamique variant dans le temps. On utilise ensuite ce changement d'état dans les différents circuits reliés à la mémoire.

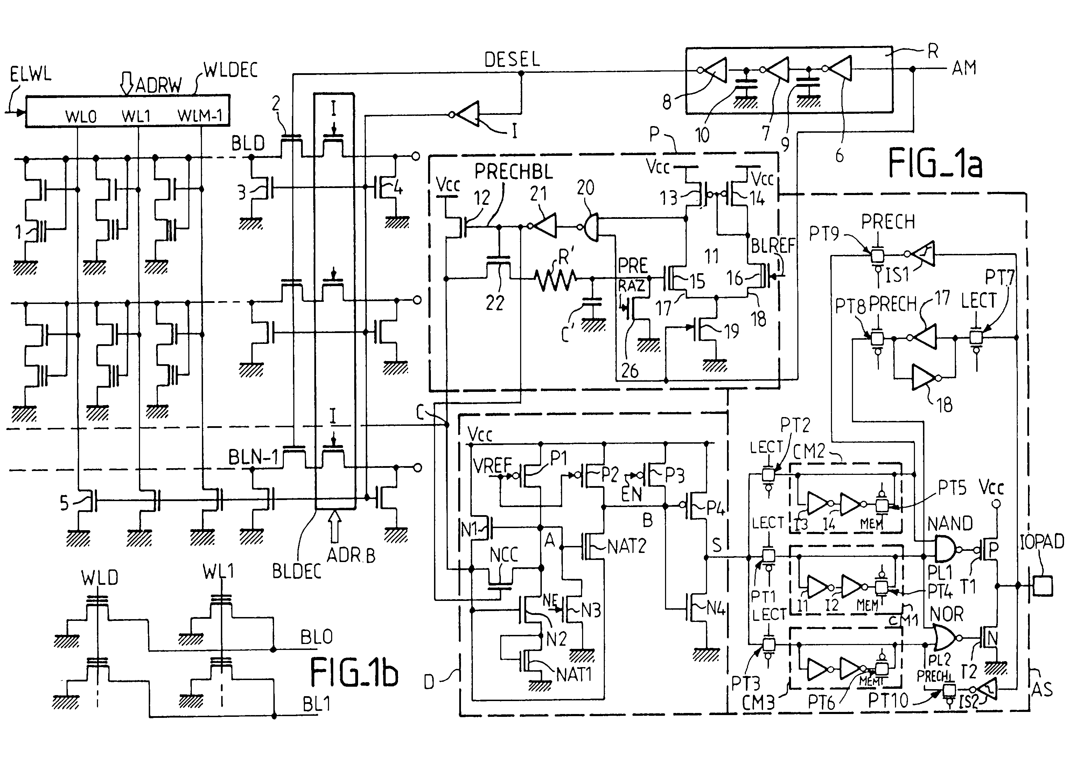

Tel qu'il vient d'être décrit, le processus nécessite la précharge de la ligne de bits à une certaine tension, avant la sélection du point mémoire concerné par la ligne de mots. Le détecteur de courant est relié à la ligne de bits au moins à la fin de cette précharge. Dès que la ligne de mots concernée est activée, le phénomène de court circuit ou de circuit ouvert se produit et du courant passe ou ne passe pas dans le détecteur de courant. Etant donné que le détecteur de courant est ainsi relié au préalable à la ligne de bits, il a été mis au point des procédés de précharge de la ligne de bits dans lesquels le circuit de précharge de la ligne de bits est intégré au détecteur de courant. Un circuit D et P de détection et de précharge de ce type est reconnaissable sur la figure 1. Cette figure concerne l'invention mais montre également l'état de la technique avec le détecteur de courant D. Avec un tel circuit, on arrive à précharger des lignes de bits, assimilables au moment de la précharge ou de la lecture à un circuit RC, au bout d'une durée sensiblement égale à 10 ns.

Avant la précharge, dans le cas des mémoires EEPROM, il est cependant nécessaire de remettre les lignes de bits et lignes de mots à zéro de façon à ce que la précharge s'effectue correctement, notamment pour que d'une part elle commence, et pour d'autre part que les tension de précharge des différentes lignes de bits soient les mêmes. Dans le cas des mémoires EPROM, il faut porter les lignes de mots à la masse, ou à une tension inférieure à la tension de lecture pour ne pas affecter les cellules. Avant la précharge dans ce cas, les lignes de bits sont portées à haute impédance : elles sont déconnectés des circuits de détection. En pratique toutes ces connexions et impositions de tension dépendent d'une part de la technologie retenue (EPROM-EEPROM) et d'autre part, du mode de réalisation des circuits de lecture.

Les problèmes rencontrés avec les mémoires de ce type sont pour une grande part liés à leur rapidité. Par exemple pour la lecture, les opérations de mise à zéro des lignes de bits, de précharge de lignes de bits, de lecture, et de mémorisation de lecture doivent durer moins que la durée nominale annoncée pour une gamme de circuits. Le respect de cette rapidité est cependant de plus en plus difficile à obtenir compte tenu de ce que les tailles des mémoires ont tendance à augmenter. De ce fait ces lignes de bits et lignes de mots sont plus longues et la durée de propagation des signaux devient importante. Elle conduit à ne plus pouvoir respecter la durée nominale. Pour accélérer ces opérations il a déjà été prévu, dans la demande de brevet français N° 89 déposée le 02 Octobre 1989 et publiée sous le N° 2 652 672, de rendre la précharge des lignes de bits plus rapide. Dans une demande de brevet français N° 92 09197, déposée le 24 Juillet 1992, il a été imaginé de précharger également un amplificateur de sortie de façon à ne pas avoir à supporter comme retard à la transmission le temps de montée de cet amplificateur. Toutes ces solutions sont néanmoins encore insuffisantes.

La présente invention a pour objet de remédier à ce problème en organisant différemment les diverses opérations de lecture dans une mémoire. Notamment, plutôt que de conserver une séquence: remise à zéro des lignes de bits ou lignes de mots, précharge de ces lignes, lecture des points mémoires, puis éventuellement mémorisation de lecture, l'invention préconise une séquence inversée. Dans la séquence inversée, on précharge, on lit, éventuellement on mémorise ce qui a été lu, puis, après une durée calibrée après la lecture, on remet à zéro les lignes de bits ou les lignes de mots ou encore on les met à haute impédance selon la technologie choisie.

De ce fait on peut avoir une séquence plus rapide puisque finalement on a anticipé, à la fin de la lecture une des opérations relative à une lecture suivante. En pratique avec des lectures successives dans la mémoire, on effectue dans le même ordre les mêmes opérations, mais une de ces opérations, la désélection des lignes de bits et lignes de mots préalablement sélectionnées, est effectuée à la fin d'un cycle de lecture et non pas au début de ce cycle comme dans l'état de la technique. On montre qu'on peut alors gagner environ 5 nanosecondes sur un cycle de lecture complet puisque cette remise à zéro est faite pendant une période qui autrement était neutralisée, par exemple pour attente de la fin de la lecture avant d'autoriser une lecture suivante.

En outre, en agissant de cette façon, tant qu'une ligne de bit n'est pas sélectionnée, elle est dans un état de tension non critique. En effet, dans l'état de la technique lorsqu'une ligne de bits avait été lue, mais qu'aucun de ses points mémoires n'avait été équivalent à un court circuit, la tension présente sur cette ligne de bit reste élevée, par exemple 3 volts. A terme, une telle excitation appliquée sur une région de source d'un transistor à grille flottante peut conduire à une légère programmation de ce transistor. La mémoire se programme spontanément. Ceci est d'autant plus critique pour les mémoires EPROM Flash que celles-ci, comme les mémoires EPROM, ne possèdent pas de transistor de commande en série et que, comme les mémoires EEPROM, elles possèdent un oxyde de grille fin. Elles sont donc en permanence sollicitées.

On n'est par ailleurs pas nécessairement obligés de remettre à zéro les lignes de bits. Selon les technologies de fabrication et les circuits de lecture utilisés, on peut se contenter de mettre les lignes de bits en haute impédance (elles ne sont plus reliées à des sources de tension élevées du circuit), et en général on connecte les lignes de mots à la masse pendant cette opération de remise à zéro.

L'invention a donc pour objet une mémoire en circuit intégré comportant
- des points mémoires non volatiles avec, comme élément de mémorisation, un transistor à grille flottante, et qui sont adressés par des lignes de bits et des lignes de mots,
- un circuit dit de déselection relié à ces lignes de bits et/ou lignes de mots pour placer ces lignes de bits et/ou lignes de mots en haute impédance et/ou pour les relier à une tension de base,
- un circuit de précharge relié à ces lignes de bits pour précharger ces lignes de bits à une tension de lecture ou d'écriture, différente de la tension de base,
- et un circuit de lecture ou d'écriture commandé par un signal de lecture ou d'écriture pour lire ou écrire ces états électriques, caractérisée en ce qu'elle comporte
- un circuit de retard, déclenché par le circuit de lecture ou d'écriture, pour placer par l'intermédiaire du circuit de déselection ces lignes de bits et/ou lignes de mots en haute impédance et/ou pour les relier à une source de tension de base avec un retard calibré consécutif à la lecture ou l'écriture de ces états électriques résultant de l'application du signal de lecture ou d'écriture.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- figures 1a et 1b : la représentation schématique déjà évoquée d'une mémoire selon l'invention. En pratique on montre sur la figure la une mémoire EPROM, parce que son circuit de lecture est un petit peu plus compliqué. Une mémoire EPROM est rappelée figure 1b ;
- figures 2a à 2f : des diagrammes temporels de signaux mis en oeuvre dans l'invention.

La figure 1a montre une mémoire conforme à l'invention du type dont les points mémoires tels que 1 comportent un transistor à grille flottante et qui sont reliés à des lignes de bits BL0 à BLN-1 et des lignes de mots WL0 à WLM-1. Ces lignes de bits et lignes de mots sont par ailleurs reliées à des décodeurs respectivement BLDEC et WLDEC de lignes de bits et de lignes de mots. La mémoire comporte un circuit dit de déselection également relié à ces lignes de bits et/ou lignes de mots pour placer ces lignes de bits et/ou lignes de mots en haute impédance et/ou pour les relier à une source de tension de base. Par exemple ce circuit de désélection comporte d'une part des transistors de type N tels que le transistor 2, en série avec les lignes de bits et mettant en relation ces lignes de bits avec des sorties du décodeur BLDEC lorsqu'ils reçoivent sur leur grille de commande un signal DESEL de désélection à un état un. Lorsqu'il reçoivent un signal DESEL à un état zéro ils sont bloqués. Les lignes de bits sont en l'air, elles sont découplées du décodeur BLDEC.

Le circuit de désélection comporte également des transistors de type N tels que les transistors 3 et 4 recevant sur leur grille de commande un signal complémentaire du signal DESEL produit par un inverseur I, et qui sont connectés par leur régions de drain et source d'un coté à une ligne de bit et de l'autre à la masse. Dans ce cas la tension de base est la tension de masse, mais ce n'est pas un obligation. Le transistor 3 est placé d'un coté du décodeur BLDEC correspondant physiquement à la place de la ligne de bit, le transistor 4 est placé sur la même ligne de bit de l'autre coté du décodeur BLDEC correspondant détecteur D. Lorsque DESEL vaut zéro, la ligne de bit et les entrées et sorties du décodeur BLDEC sont ainsi portées à masse.

Le circuit de désélection comporte enfin des transistors tels que 5 de type N reliés entre les lignes de mot et la masse et recevant aussi le complémentaire du signal DESEL sur leur grille de commande. Au moment de la désélection, lorsque le signal DESEL vaut un, les lignes de mots sont ainsi portées à la masse.

On pourrait concevoir un autre circuit, notamment avoir des transistors de types opposés, commandés par des signaux de type également opposés. On pourrait aussi pendant la phase de remise à zéro se contenter de mettre les lignes de bits en haute impédance. Sur la figure 1b on montre une cellule mémoire de type EPROM dans laquelle le transistor à grille flottante est directement raccordé par son drain à la ligne de bit et par sa source à la masse. La grille de commande de ce transistor est connectée à la ligne de mot. Le principe de lecture est le même.

La mémoire comporte encore un circuit de précharge P relié à ces lignes de bits pour précharger ces lignes de bits à une tension de lecture ou d'écriture, différente de la tension de base. En pratique, si la tension d'alimentation Vcc du circuit est de 3 volts, une tension de précharge de lecture est de l'ordre de 1,2 volts. Elle comporte également un circuit de lecture D commandé par un signal de lecture AM pour lire ces états électriques. Le signal AM est en pratique un signal produit par un adressage de la mémoire. Dés la réception d'un signal de transition d'adresse sur un bus d'adresse de la mémoire, on produit par un circuit de type connu le signal AM. Ce signal peut aussi être le signal de lecture classique d'une mémoire et être produit à l'extérieur du circuit intégré. On assimile ainsi au circuit de lecture les circuits qui concourent à la lecture d'une cellule, notamment, si c'est le cas, un circuit non représenté de détection de transitions d'adresse.

Une caractéristique importante de l'invention est que la mémoire comporte un circuit de retard R, déclenché par le circuit de lecture (par exemple par le signal AM produit pour ce circuit de lecture) pour placer ces lignes de bits et/ou lignes de mots en haute impédance et/ou pour les relier à une tension de base, avec un retard calibré consécutif à la lecture de ces états électriques résultant de l'application du signal de lecture. Dans un exemple le circuit R comporte une ligne à retard analogique constituée de cellules inverseuses 6 à 8 en série et dont les noeuds de connexion sont reliés par des capacités 9 à 10 à une tension fixe, par exemple la masse. Lorsqu'une impulsion est transmise à une telle série de cellules, la sortie de cette impulsion est retardée par le temps mis à charger les capacités interposées en parallèle. Ce circuit de retard est capable dans le cas présent de proposer un retard de l'ordre de 40 nanosecondes. On peut prévoir en plus des prises intermédiaires pour disposer de retards moins longs.

Les fonctionnements des circuits D de détection et P de précharge sont les suivants. Au départ, une ligne de bits quelconque sélectionnée est connectée à un noeud C, alors que le signal DESEL vaut un. Le potentiel de la ligne de bits concernée est alors à VSS, égal à zéro volts. Pour précharger la ligne de bits on active le détecteur D, par exemple au moyen d'un signal VREF qui est appliqué sur la grille d'un transistor P1 de type p. Le transistor P1 est relié d'une part à Vcc (tension d'alimentation) et d'autre part à un noeud A. La commande par VREF a pour objet de porter A à la valeur de Vcc. Ce faisant, un transistor N1 de type N, qui est relié par son drain au potentiel Vcc et qui reçoit le potentiel du noeud A sur sa grille, devient conducteur. Il en est de même d'un transistor natif NAT2 qui reçoit le potentiel du noeud A sur sa grille et dont le drain est également relié à Vcc par la mise en conduction d'un transistor P2 de type P. Le transistor P2 est commandé lui aussi par le potentiel de commande VREF. Les transistors N1 et NAT2 chargent alors la ligne de bits à laquelle ils sont reliés au noeud C par leur source. La tension du noeud C monte. Comme la tension du noeud C monte, on provoque la mise en conduction d'un transistor N2 de type N. Le transistor N2 est en cascade, entre le transistor P1 et un transistor NAT1 de type N, entre Vcc et la masse. Le transistor N2 reçoit la tension du noeud C sur sa grille. Le transistor NAT1 est monté en diode à cause de la connexion de sa grille à son drain.

Une contre réaction s'exerce alors sur la tension du noeud A. La tension du noeud A se stabilise donc à une tension intermédiaire déterminée par les transistors P1, N2 et NAT1. Le transistor NAT1, du fait que sa grille est court circuitée à son drain, se comporte comme une diode : il sert à augmenter la tension du noeud A dès qu'un courant passe dans le transistor N2 et dans le transistor NAT1. La tension au noeud C est alors égale à la tension de seuil de conduction VT du transistor N2 (VTN2) additionnée à la tension de seuil de conduction du transistor NAT1 (VTNAT1), c'est-à-dire 1,2 volts.

En effet, si la tension en C monte, les transistors N2 et NAT1 ont tendance à davantage conduire et font baisser la tension sur le noeud A. La tension C décroît alors naturellement, par le fait que les transistors N1 et NAT2 deviennent alors moins conducteurs. Par contre, si la tension en C baisse, ces deux transistors tendent à plus conduire et le phénomène inverse se produit. Ainsi les transistors N1 et NAT2 chargent la ligne de bits jusqu'à ce que la tension C ait atteint cette valeur.

Au moment de la lecture, la ligne de bits à lire peut être considérée ou non comme une résistance faible de liaison du noeud C à la masse, selon l'état de programmation du point mémoire à lire dans cette ligne de bits. Lorsqu'il y a une liaison à la masse la tension au noeud C chute brutalement et le transistor NAT2 doit laisser passer beaucoup de courant. Comme la commande du transistor NAT2 n'a pas varié, puisque la tension du noeud A reste au même potentiel pendant la lecture, il en résulte que la tension d'un noeud B intermédiaire entre le transistor P2 et le transistor NAT2 remonte brutalement. Par contre, si au moment de la lecture on n'a pas détecté de court circuit, la tension au noeud B reste à sa valeur initiale basse. Un montage inverseur de sortie P4-N4 connecté à ce noeud B, bascule, ou respectivement, ne bascule pas, en fonction de cette lecture. La sortie S délivre respectivement un signal haut (Vcc) ou un signal bas (Vss).

L'essentiel de la lenteur de la charge des lignes de bits provient du circuit de contre réaction NAT2-N2-NAT1. Pour remédier à cet inconvénient on utilise par ailleurs un circuit de précharge P des lignes de bits qui est indépendant du détecteur D lui-même et qui est beaucoup plus puissant. Par ailleurs pour éviter les disparités de fabrication ainsi que pour limiter l'encombrement d'implantation dû à un circuit supplémentaire plus puissant de pré-charge, on peut prévoir de court circuiter toutes les lignes de bits à précharger, ensemble, au moment de la précharge. De ce fait on obtient à la fois une précharge rapide, identique pour toutes les lignes et sans un notable encombrement supplémentaire. Le circuit de précharge P comporte un amplificateur différentiel 11. Cet amplificateur différentiel 11 reçoit d'une part un signal de référence de tension de ligne de bits BLREF qui doit être comparé à un signal PRE de précharge effective de la ligne de bits. Cet amplificateur différentiel 11 délivre un signal PRECHBL de commande de précharge de la ligne de bits. Ce signal de commande de précharge de la ligne de bits est appliqué en commande à un transistor de puissance 12 qui est connecté au noeud C à la ligne de bits pour la précharger. Par son autre borne le transistor 12 est relié à l'alimentation Vcc du circuit.

La structure du circuit P est la suivante. Deux transistors de type P enrichis, respectivement 13 et 14, sont montés en cascade avec deux transistors de type N natifs, respectivement 15 et 16, reliés ensemble par leurs sources respectivement 17 et 18. Le noeud commun des sources 17 et 18 est par ailleurs relié à la masse par un transistor 19 de type N. Les transistors natifs 15 et 16 forment l'étage différentiel. Ils reçoivent sur leur grille respectivement les signaux PRE et BLREF. Les deux grilles des deux transistors P 13 et 14 sont reliées ensemble et sont reliées en même temps au drain du transistor 14. Les transistors 13 et 14 forment un miroir de courant pour imposer des courants proportionnels dans les deux branches de l'amplificateur 11.

Au début de la précharge, la tension disponible sur la ligne de bits, au noeud C, est nulle. En conséquence le signal de précharge de la ligne de bits PRE est nul. Lorsqu'on veut précharger on envoie un signal positif AM sur la grille de commande du transistor 19. Ce faisant les sources 18 et 17 des transistors natifs 16 et 15 peuvent être considérées comme reliées à la masse. L'amplificateur différentiel 11 est alors mis en service. Au moment de la connexion à la masse des sources 17 et 18, les transistors 14 et 16 se mettent à conduire. En conséquence le transistor 13 se met à conduire également. Cependant, comme le signal de précharge effectif PRE appliqué sur la grille de commande du transistor natif 15 est alors nul, la tension drain source du transistor 15 est grande. En conséquence le drain du transistor 13 est porté au potentiel d'alimentation : Vcc. Le potentiel du drain du transistor 13 ainsi que l'ordre AM de validation du fonctionnement de l'amplificateur différentiel sont appliqués sur les entrées d'une porte NON-ET 20 qui délivre alors un état logique zéro. Cet état logique zéro est introduit sur l'entrée d'un inverseur 21 qui délivre un signal de commande de précharge des lignes de bits PRECHBL maintenant à l'état un. Cet ordre à l'état un rend conducteur le transistor 12 de charge de la ligne de bits.

Le signal de précharge de la ligne de bits est par ailleurs prélevé au noeud C et est conduit, par l'intermédiaire d'un circuit de simulation R'C', sur la grille de commande du transistor natif 15 en tant que signal PRE. Le circuit R'C' est un circuit de simulation de la charge d'une ligne de bits. Ce circuit R'C' existe réellement : son indication n'est pas symbolique ici. Le but de ce circuit est de connaître la tension effective de précharge de la ligne de bits, au bout de la ligne de bits, et non pas à son entrée. Le point milieu du circuit R'C' délivre donc un signal PRE de précharge effective de la ligne de bits.

On aurait pu remplacer le circuit R'C' par une ligne de bits réelle, supplémentaire, par exemple du type de celle utilisée en réparation. Néanmoins le choix d'un circuit R'C' est préféré parce qu'il occupe moins de place. Par ailleurs, comme on précharge plusieurs lignes de bits en même temps, il faudrait créer une simulation de la précharge de plusieurs lignes de bits en même temps, ce qui ne peut pas être équivalent à la pré-charge d'une seule ligne de bits.

Dès que le signal de précharge effective de la ligne de bits a atteint le niveau imposé par le signal de référence BLREF, la tension drain source du transistor 15 se met à décroître, l'amplificateur différentiel 11 bascule, et le signal de commande de précharge de ligne de bits PRECHBL bascule : il repasse à l'état zéro. Ce faisant, le transistor 12 se bloque. A ce moment la précharge est terminée et la ligne de bits est disponible pour la lecture proprement dite. Par ailleurs un transistor 22, placé en série entre le noeud C et le circuit R'C', et également commandé par le signal de commande de précharge PRECHBL, se bloque lui aussi. Il découple alors l'amplificateur différentiel 11 du circuit de lecture de la mémoire. Ce faisant on évite de fausser la mesure de la chute de tension au noeud C du fait de la présence des capacités de l'amplificateur différentiel 11 (et de celle du circuit R'C') qui pourrait retarder le basculement de l'inverseur P4 N4.

On peut profiter de la présence du signal de commande de précharge de ligne de bits pour court-circuiter ensemble toutes les lignes de bits. Le fait de court circuiter ensemble au moment de la précharge toutes les lignes de bits a pour second avantage d'assurer que toutes les lignes de bits seront préchargées à une même valeur, et que cette valeur est ainsi indépendante des disparités des caractéristiques des transistors de précharge des détecteurs eux-mêmes.

Pour que l'amplificateur différentiel 11 soit très rapide, les transistors de type p 13 et 14 sont de préférence de gros transistors. Par ailleurs les transistors de comparaison 15 et 16 sont de préférence des transistors natifs. En effet, la zone de bon fonctionnement d'un amplificateur différentiel de type n est comprise entre 2VT et Vcc. Or, la tension de seuil VT d'un transistor de type n normal (c'est-à-dire enrichi) est de l'ordre de 1.5 volt. En conséquence un amplificateur différentiel de ce type fonctionnerait bien lorsque les tensions à comparer, PRE et BLREF seraient supérieures à 3 volts et inférieures à Vcc. Or ce n'est pas le cas puisque la tension de précharge à obtenir est de 1.2 volts. En retenant des transistors natifs, dont la tension de seuil de conduction VT est de l'ordre de 0.2 volts, on aboutit facilement dans une bonne plage de fonctionnement.

La présence de l'amplificateur différentiel 11 permet de précharger les lignes de bits comme si on voulait atteindre une valeur de précharge de Vcc au moyen du transistor 12. La constante de temps de précharge des lignes de bits n'est pas changée. Cependant, compte tenu que l'objectif de tension que l'on se fixe est supérieur, on atteint plus rapidement le seuil de 1.2 volt que si on avait visé justement l'obtention de ce seuil. L'amplificateur différentiel permet de couper la pré-charge dès que cette tension a été atteinte. De plus, avec l'amplificateur différentiel 11, la contre-réaction NAT2, NAT1, N2 ne devient plus prépondérante.

Selon l'invention, en outre, un amplificateur de sortie AS fonctionne selon deux phases : précharge d'abord, puis transmission du niveau logique du signal S. L'amplificateur AS comporte deux transistors de sortie qui servent à fournir le niveau logique désiré sur un plot IOPAD. Ce sont respectivement un transistor de charge T1 et un transistor de décharge T2. En technologie CMOS on utilisera un transistor de charge à canal P, ayant sa source reliée à une borne d'alimentation positive Vcc, et un transistor de décharge à canal N, ayant sa source reliée à une borne d'alimentation basse, la masse par exemple. Les drains des transistors sont reliés au plot IOPAD. Le transistor T1 doit être conducteur et T2 bloqué lorsque le signal S correspond à la mise au niveau logique haut du plot IOPAD; inversement, le transistor T1 doit être bloqué et le transistor T2 conducteur lorsque le signal S correspond à la mise au niveau logique bas du plot.

On comprend que si une première lecture d'information a conduit à mettre le plot IOPAD à un potentiel haut, la deuxième lecture fournira une information rapide si elle doit également conduire à un niveau haut, mais plus lente si elle doit conduire à un niveau bas car dans ce deuxième cas il faudra prendre le temps de décharger le plot et les lignes extérieures connectées à ce plot. Inversement, si la lecture précédente a placé le plot à un niveau bas, l'obtention d'une information sera retardée si la nouvelle information correspond à un niveau logique haut.

Pour équilibrer la rapidité de fourniture de l'information dans les deux cas possibles (fourniture successive de deux niveaux identiques ou fourniture de deux niveaux différents), on précharge le plot de sortie à une valeur intermédiaire entre les deux niveaux logiques, pendant une phase de précharge précédant immédiatement la lecture proprement dite. Les niveaux logiques considérés ici sont les niveaux standards admis dans la technologie utilisée. Par exemple, en technologie CMOS ces niveaux peuvent être de 0,8 volts pour le niveau bas et de 2 volts pour le niveau haut. La valeur intermédiaire pourra être d'environ 1,4 volts. Le séquencement des opérations comportera donc, à partir d'un instant t0 défini par la détection d'un changement d'adresse AM d'information à lire, d'abord une phase de précharge PRECH (t0 à t1, durée de l'ordre de 30 nanosecondes par exemple), puis une phase de lecture LECT (t1 à t2, de l'ordre de 10 nanosecondes), puis une phase d'attente d'un nouveau changement d'adresse d'information à lire.
On notera que cette phase supplémentaire de précharge des plots IOPAD peut ne pas perdre de temps si elle peut être effectuée en même temps que la phase de précharge de la ligne de bit BL, avant l'élaboration du signal S. Avec l'invention on pourrait même anticiper cette précharge en la déclenchant par la fin d'une lecture précédente.

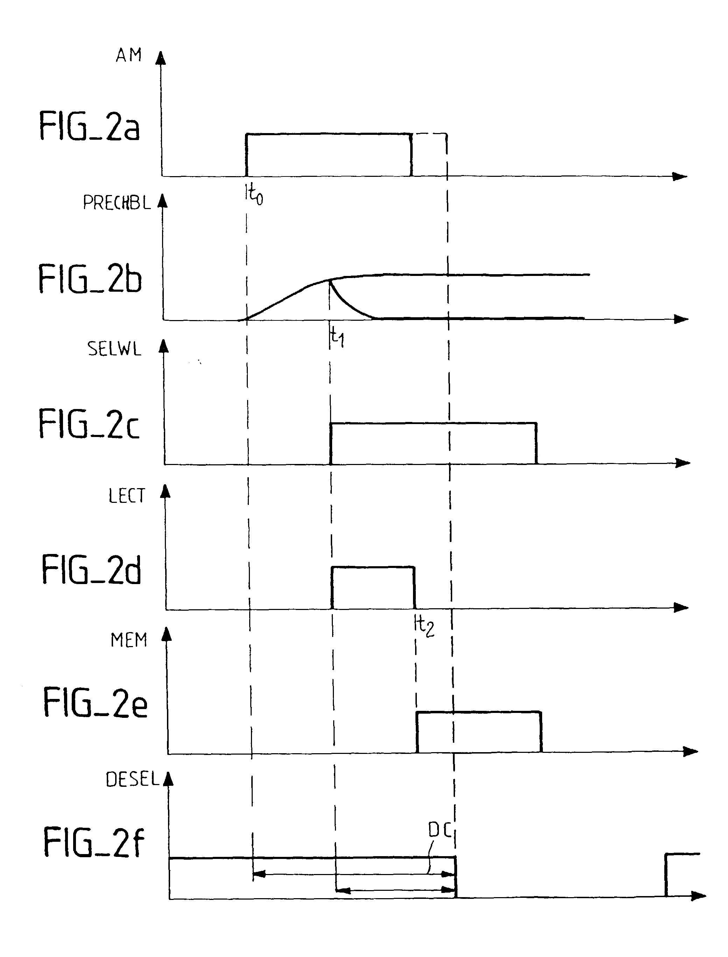

Une première porte logique PL1 commande la grille du transistor T1, et une deuxième porte logique PL2 commande la grille du transistor T2. Dans l'exemple représenté, la porte logique PL1 est une porte NAND à deux entrées, et la porte logique PL2 est une porte NOR à deux entrées. La première entrée de la porte NAND PL1 reçoit, au moment de la phase de lecture, le signal S représentant l'information à transmettre sur le plot de sortie. La première entrée de la porte NOR reçoit le même signal. La sortie de l'amplificateur N4-P4 est reliée à ces premières entrées par l'intermédiaire d'une porte de transfert PT1 ouverte seulement pendant la phase de lecture proprement dite, après la phase de précharge. Le signal LECT qui commande certaines portes de transfert de la figure définit cette phase de lecture (voir figures 2). Les portes de transfert sont constituées par un transistor MOS à canal N commandé par un signal logique, en parallèle avec un transistor MOS à canal P commandé par un signal logique complémentaire.

La deuxième entrée de la porte NAND PL1 reçoit également le signal S à travers une autre porte de transfert PT2, passante pendant la phase de lecture LECT. De la même façon, la première entrée de la porte NOR PL2 reçoit le signal S à travers la porte PT1 et la deuxième entrée reçoit le signal S à travers une porte de transfert PT3 rendue passante par le signal LECT.

Pour des raisons qui tiennent à la nécessité de libérer très rapidement l'amplificateur différentiel P4-N4 pour une nouvelle lecture avant même que l'information ne soit complètement stabilisée sur le plot IOPAD, on prévoit des circuits de maintien auxiliaires qui mémorisent et maintiennent la valeur du signal S sur les entrées des portes logiques PL1 et PL2 même après disparition du signal S. Il y a aussi un circuit de maintien après chaque porte de transfert PT1, PT2, PT3. Chaque circuit de maintien, respectivement CM1, CM2, CM3, comporte une boucle asservie comprenant deux inverseurs en cascade, en série avec une porte de transfert. L'entrée du deuxième inverseur est connectée à la sortie du premier, la sortie du deuxième inverseur est reliée à l'entrée de la porte de transfert, et la sortie de cette dernière est rebouclée sur l'entrée du premier inverseur. La porte de transfert du circuit de maintien est commandée par un signal MEM qui assure la sauvegarde de l'information (S) dès que le signal S correspondant à une nouvelle lecture a pris sa nouvelle valeur. Le signal MEM apparaît dès la fin de la phase de lecture (LECT) et est maintenu normalement jusqu'à la phase de précharge suivante, c'est-à-dire pendant tout le temps d'attente avant la détection d'un changement d'adresse d'information à lire.

Le premier circuit de maintien CM1, correspondant à un double inverseur I1, I2 et une porte de transfert PT4, est connecté à la sortie de la porte PT1, c'est-à-dire que l'entrée de l'inverseur I1 et la sortie de la porte PT4 sont reliées à cette sortie de la porte PT1.

De la même façon, le deuxième circuit de maintien CM2 (inverseurs I3, I4, porte de transfert PT5 commandée par le signal MEM) est relié à la sortie de la porte de transfert PT2. Le troisième circuit de maintien CM3 (inverseurs I5, I6, porte de transfert PT6 commandée par le signal MEM) est relié à la sortie de la porte de transfert PT3.

Lorsque le signal LECT est émis pour appliquer le signal S aux portes PL1 et PL2, le signal MEM est à l'état bas (portes PT4, PT5, PT6 bloquées). Le signal de lecture LECT rend conductrices les portes PT1, PT2, PT3; le signal S apparaît sur les entrées des portes PL1 et PL2 puis se stabilise; le signal LECT peut alors être remis à l'état bas et le signal MEM appliqué est appliqué aux portes PT4, PT5, PT6 pour les rendre passantes et activer les circuits de maintien pour mémoriser le signal S. La valeur logique du signal S reste alors appliquée aux entrées des portes logiques PL1 et PL2 même si la sortie de l'amplificateur P4-N4 cesse de fournir le signal S. On peut donc effectuer dès cet instant l'opération de désélection qui réinitialise le détecteur D.

Si le signal S est à un niveau logique haut (1), la sortie de la porte NAND passe à zéro puisque ses deux entrées sont à 1. Le transistor de charge T1 est alors rendu conducteur, chargeant le plot IOPAD au niveau logique haut à partir de la borne d'alimentation haute A. Le transistor T2 reste bloqué, la sortie de la porte NOR étant à 0 du fait que ses deux entrées sont à 1.

Si au contraire le signal S est à un niveau logique bas (0), la sortie de la porte NOR passe à 1 et rend conducteur le transistor de décharge T2 pour faire passer au niveau 0 le plot de sortie. La porte NAND fournit un niveau 1 qui bloque le transistor T1.

Pour la précharge de l'amplificateur AS, les éléments spécifiques supplémentaires suivants sont de préférence prévus : un circuit d'inhibition de l'une des portes PL1 et PL2 en fonction de l'état logique précédent du plot IOPAD, et un détecteur à seuil pour limiter la précharge du plot IOPAD à une valeur déterminée.

Sur la réalisation préférée, on a prévu un circuit de mémorisation de la valeur logique précédente du plot IOPAD. Ce circuit comporte par exemple un inverseur I7 rebouclé par un autre inverseur I8 plus résistif que le premier. L'entrée de ce circuit de mémorisation (entrée de l'inverseur I7) est reliée au plot par l'intermédiaire d'une porte de transfert PT7 rendue passante pendant la phase de lecture LECT. Le circuit de mémorisation mémorise donc l'état du plot pendant la phase de lecture. La sortie du circuit de mémorisation (sortie de l'inverseur I7) est reliée à la première entrée de la porte NAND PL1 et à la première entrée de la porte NOR PL2, par l'intermédiaire d'une porte de transfert PT8 rendue passante pendant la phase de précharge PRECH. L'état logique présent sur le plot, inversé par l'inverseur I7 et mémorisé par cet inverseur, est donc transmis à l'entrée des portes NAND et NOR pendant toute la phase de précharge.

La sortie du circuit de mémorisation sert simplement à inhiber le fonctionnement de l'une ou l'autre des portes PL1 et PL2 pour interdire la conduction du transistor de charge ou du transistor de décharge selon l'état logique du plot à la lecture précédente : si l'état logique mémorisé est 1, un état 0 est transmis à l'entrée de la porte NAND pendant la phase de précharge suivante, ce qui interdit la conduction du transistor T1 quel que soit l'état de l'autre entrée; la porte NOR n'est pas affectée et peut faire conduire le transistor T2 selon l'état de l'autre entrée de cette porte. Inversement, si l'état du plot à la lecture précédente est 0, un état 1 est transmis par le circuit de mémorisation lors de la phase de précharge suivante pour venir interdire la conduction du transistor T2; la conduction du transistor T1 ne sera pas inhibée et dépendra de l'état de l'autre entrée de la porte NAND.

La deuxième entrée de la porte NAND PL1 reçoit la sortie d'une porte de transfert PT9 qui elle-même reçoit la sortie d'un inverseur à seuil IS1, l'entrée de ce dernier étant relié au plot IOPAD. On rappelle que la deuxième entrée de la porte NAND reçoit par ailleurs le signal S par la sortie du circuit de maintien CM2. Mais pendant la phase de précharge PRECH, le signal LECT et le signal MEM sont à zéro, bloquant les portes PT2 et PT5, de sorte que le signal S n'est plus transmis activement sur les entrées des portes NAND et NOR.

De la même manière, la deuxième entrée de la porte NOR PL2, qui ne reçoit plus le signal S de la lecture précédente pendant la phase de précharge PRECH, reçoit, par l'intermédiaire d'une porte de transfert PT10 activée par le signal PRECH, la sortie d'un inverseur à seuil IS2.

Les inverseurs à seuil servent à autoriser la mise en conduction de celui des transistors T1 ou T2 dont la conduction n'est pas interdite par le circuit d'inhibition pendant la précharge. Cette conduction est autorisée tant que le potentiel du plot n'a pas atteint la valeur intermédiaire de précharge désirée; elle est arrêtée ensuite.

Le seuil des inverseurs IS1 et IS2 est réglé à une valeur qui est directement liée à la valeur du potentiel de précharge qu'on veut appliquer sur le plot IOPAD pendant la phase de précharge.

En effet, le circuit fonctionne de la manière suivante : si le signal S de la lecture précédente est à 1, le plot est chargé à environ 5 volts à la fin de l'étape de lecture. Pendant la phase de précharge qui prépare la lecture suivante, la porte NAND est inhibée par la sortie de la porte PT8. La porte NOR reçoit un état logique 0 sur sa première entrée par la porte PT8 et un état logique 0 par l'inverseur à seuil puisque le plot est à 1. La porte NOR fournit à sa sortie un niveau haut; le transistor de décharge T2 devient conducteur et décharge le potentiel haut du plot IOPAD. Le potentiel de ce plot descend. Mais dès qu'il atteint la valeur de précharge désirée, définie par le seuil de l'inverseur IS2, l'inverseur IS2 bascule, fait basculer la porte NOR, et bloque le transistor T2, de sorte que la décharge du plot cesse. Le plot reste chargé à la valeur de précharge désirée intermédiaire entre un niveau logique haut et un niveau logique bas. La situation reste alors ainsi jusqu'à la fin de la phase de précharge PRECH et jusqu'à l'apparition du signal LECT qui définit la nouvelle phase de lecture.

Inversement, si le signal S de la lecture précédente était à 0, le plot est initialement déchargé à 0 volt à la fin de l'étape de lecture. Pendant la phase de précharge qui prépare la lecture suivante, c'est cette fois la porte NOR qui est inhibée par la sortie de la porte PT8. La porte NAND reçoit un état logique 1 sur sa première entrée par la porte PT8 et un état logique 1 par l'inverseur à seuil IS1 puisque le plot est à 0. La porte NAND fournit donc à sa sortie un niveau bas; le transistor de charge T1 devient conducteur et charge le plot IOPAD. Le potentiel de ce plot monte; dès qu'il atteint la valeur de précharge désirée, définie par le seuil de l'inverseur IS1, l'inverseur IS1 bascule, fait basculer la porte NAND, et bloque le transistor T1, de sorte que la charge du plot cesse. Le plot reste chargé à la valeur de précharge désirée intermédiaire entre un niveau logique haut et un niveau logique bas.

Etant donné qu'il est difficile de faire un inverseur à seuil fonctionnant sans hystérésis, c'est-à-dire basculant pour la même valeur de tension d'entrée aussi bien dans le sens des tensions croissantes que dans le sens des tensions décroissantes, on préfère utiliser deux inverseurs séparés IS1 et IS2, mais on comprendra que si on accepte un hystérésis les deux inverseurs pourraient être remplacés par un inverseur unique puisqu'ils sont connectés en parallèle.

Le niveau du potentiel intermédiaire auquel on précharge le plot est de préférence compris entre 1 et 2 volts, pour une alimentation en tension de 5 volts, et une valeur appropriée est 1,4 volts environ. Bien que l'alimentation soit de 5 volts, le niveau logique bas est considéré comme étant une valeur inférieure à 0,8 volts environ et le niveau logique haut est considéré comme atteint aux alentours de 2,2 volts. Ceci explique les valeurs indiquées comme gammes de valeurs intermédiaires préférées pour la précharge de la sortie de l'amplificateur.

Les figures 2a à 2f montrent respectivement les allures des signaux AM, PRECHBL, SELWL, LECT, MEM, et DESEL évoqués jusqu'ici. Le signal SELWL est le signal qui permet de valider le décodeur de lignes de mots de façon à effectuer concrètement la lecture d'un point mémoire. Quand ce signal est actif, le décodage des adresses de ligne de mots produit des tensions qui sont appliquées sur les lignes de mots concernées. On peut considérer que ce signal sera celui par rapport auquel on va comptabiliser le retard avant de produire le signal DESEL dans le circuit R. Ces signaux sont produit de la façon suivante. Une transition d'adresse produit le signal AM, et éventuellement après un temps connu le signal SELWL. Pendant le début du signal AM les lignes de bits connectées aux circuits P et D par le décodeur BLDEC se préchargent. A la fin de cette précharge le signal SELWL provoque la lecture des points mémoires. Dans des circuits de type connu des signaux LECT et MEM sont produits pendant la durée du signal SELWL. Puis, après une durée DC calibrée mesurée à partir du début du signal AM (ou à partir du signal SELWL selon les cas), le signal DESEL temporairement à un état zéro est produit. Le signal DESEL temporairement à zéro provoque la mise à zéro temporaire des lignes de bits puis leur reconnexion au décodeur BLDEC. Dans ce cas la mémoire est de nouveau disponible pour commencer la précharge des lignes de bits dès la réception d'une prochaine transition d'adresse. Il n'y a plus à attendre la remise à zéro préalable avant de commencer cette précharge. En pratique on peut se satisfaire d'un signal AM de durée suffisamment longue pour que, une fois retardé il serve tel quel à une mise à zéro efficace des lignes de bits et ou lignes de mots. Ainsi le signal DESEL à un état zéro a ici la même durée que le signal AM à un état un.

Cependant, on peut vouloir que le signal DESEL à zéro dure jusqu'à une prochaine transition d'adresse. Dans ce cas le signal DESEL peut être produit par une bascule D qui reçoit le signal DESEL en entrée et le signal AM retardé en entrée d'horloge. Dans ce cas la durée du signal DESEL n'est pas limitée à celle du signal AM qui est alors de préférence court.

La présence du circuit d'amplification de sortie AS, avec ses circuits de mémorisation CM1 à CM3 est alors mise à profit dans l'invention pour provoquer la désélection des lignes de bits et ou de mots pendant que ce circuit AS fournit le signal lu sur la borne IOPAD. Par exemple le signal DESEL vaut zéro pendant que le signal MEM est encore actif. De ce fait, on n'est pas obligé d'attendre, à la fin réelle d'une lecture, que la désélection se soit achevée pour autoriser une autre lecture, une autre transition d'adresse. Comme le circuit AS est interposé, il assure la fonction de mise à disposition du signal lu alors que le circuit de lecture est désélectionné. Le circuit AS est alors un relais qui permet la désélection des lignes de bits ou de mots.

## Revendications

1. Mémoire en circuit intégré comportant
- des points mémoires non volatiles avec, comme élément de mémorisation, un transistor à grille flottante (1), et qui sont adressés par des lignes de bits (BL) et des lignes de mots (WL),
- un circuit dit de désélection (I, 3, 5) relié à ces lignes de bits (BL) et/ou lignes de mots (WL) pour placer ces lignes de bits (BL) et/ou lignes de mots (WL) en haute impédance et/ou pour les relier à une tension de base,
- un circuit de précharge (P) relié à ces lignes de bits (BL) pour précharger ces lignes de bits (BL) à une tension de lecture ou d'écriture, différente de la tension de base,
- et un circuit de lecture (D, AS) ou d'écriture commandé par un signal de lecture ou d'écriture (AM) pour lire ou écrire ces états électriques,
caractérisée en ce qu'elle comporte
- un circuit de retard (R), déclenché par le circuit de lecture ou d'écriture (D, AS), pour placer, par l'intermédiaire du circuit de déselection (I, 3, 5), ces lignes de bits (BL) et/ou lignes de mots (WL) en haute impédance et/ou pour les relier à une source de tension de base, avec un retart (DC) calibré consécutif à la lecture ou l'écriture de ces états électriques résultant de l'application du signal de lecture ou d'écriture (AM).

2. Mémoire selon la revendication 1 caractérisée en ce qu'elle comporte un circuit de mémorisation (CM1, CM2, CM3) pour sauvegarder un état électrique lu, après la lecture de cet état, pour autoriser la désélection des lignes de bits (BL) et/ou lignes de mots (WL), pendant cette mémorisation, et pour présenter le signal lu en lecture.

3. Mémoire selon l'une des revendications 1 ou 2, caractérisée en ce qu'elle comporte un circuit pour relier entre elles les lignes de bits (BL) au moment de la précharge et/ou au moment de la désélection.

4. Mémoire selon l'une des revendications 1 à 3, caractérisée en ce que le circuit de retard (R) comporte une cascade de circuits inverseurs (6, 7, 8) reliés en série, une capacité (9, 10) étant connectées entre un point milieu, entre deux inverseurs, et une tension de référence.

5. Mémoire selon l'une des revendications 1 à 4, caractérisée en ce que le circuit de retard (R) est capable de procurer un temps égal au temps de cycle.

6. Mémoire selon l'une des revendications 1 à 5, caractérisée en ce que le circuit de retard (R) comporte un circuit avec un retard plus long que le retard calibré pour déclencher un circuit de précharge du circuit de lecture.

## Claims

1. Integrated circuit memory having
- non-volatile memory locations with, as a storage element, a floating gate transistor (1), and which are addressed by bit lines (BL) and word lines (WL),
- a so-called deselection circuit (I, 3, 5) connected to these bit lines (BL) and/or word lines (WL) to put these bit lines (BL) and/or word lines (WL) at a high impedance and/or to connect them to a base voltage,
- a precharging circuit (P) connected to these bit lines (BL) to precharge these bit lines (BL) at a reading or writing voltage different from the base voltage,
- and a reading or writing circuit (D, AS) controlled by a reading or writing signal (AM) to read or write these electrical states,
characterised in that it includes
- a delay circuit (R) triggered by the reading or writing circuit (D, AS), to put, by means of the deselection circuit (I, 3, 5), these bit lines (BL) and/or word lines (WL) at a high impedance and/or to connect them to a base voltage source, with a calibrated delay (DC) following on from the reading or writing of these electrical states resulting from the application of the reading or writing signal (AM).

2. Memory according to Claim 1, characterised in that it has a storage circuit (CM1, CM2, CM3) for saving an electrical state read, after the reading of this state, for allowing the deselection of the bit lines (BL) and/or word lines (WL) during this storage, and for presenting the signal read during reading.

3. Memory according to one of Claims 1 or 2, characterised in that it has a circuit for interconnecting the bit lines (BL) at the time of precharging and/or at the time of deselection.

4. Memory according to one of Claims 1 to 3, characterised in that the delay circuit (R) has a cascade of inverter gates (6, 7, 8) connected in series, a capacitor (9, 10) being connected between a mid-point, between two inverters, and a reference voltage.

5. Memory according to one of Claims 1 to 4, characterised in that the delay circuit (R) is capable of offering a time equal to the cycle time.

6. Memory according to one of Claims 1 to 5, characterised in that the delay circuit (R) has a circuit with a delay longer than the calibrated delay, to trigger a circuit for precharging the reading circuit.

## Patentansprüche

1. Integrierte Speicherschaltung, mit
- nichtflüchtigen Speicherplätzen, die als Speicherelement einen Transistor mit schwebendem Gate (1) enthalten und die durch Bitleitungen (BL) und durch Wortleitungen (WL) adressiert werden,
- einer sogenannten Abwählschaltung (I, 3, 5), die mit diesen Bitleitungen (BL) und/oder Wortleitungen (WL) verbunden ist, um diese Bitleitungen (BL) und/oder Wortleitungen (WL) auf hohe Impedanz zu setzen und/oder sie mit einer Basisspannung zu verbinden,
- einer Vorladungsschaltung (P), die mit diesen Bitleitungen (BL) verbunden ist, um diese Bitleitungen (BL) auf eine Lese- oder Schreibspannung vorzuladen, die von der Basisspannung verschieden ist,
- und einer Lese- oder Schreibschaltung (D, AS), die durch ein Lese- bzw. Schreibsignal (AM) gesteuert wird, um diese elektrischen Zustände zu lesen bzw. zu schreiben,
dadurch gekennzeichnet, daß sie enthält
- eine Verzögerungsschaltung (R), die durch die Lese- oder Schreibschaltung (D, AS) ausgelöst wird, um über die Abwählschaltung (I, 3, 5) diese Bitleitungen (BL) und/oder Wortleitungen (WL) auf hohe Impedanz zu setzen und/oder um sie mit einer Basisspannungsquelle zu verbinden, wobei die Verzögerungsschaltung (R) eine kalibrierte Verzögerung (DC) besitzt, die auf das Lesen oder Schreiben derjenigen elektrischen Zustände folgt, die sich durch Anlegen des Lese- bzw. Schreibsignals (AM) ergeben.

2. Speicher nach Anspruch 1, dadurch gekennzeichnet, daß er eine Speicherschaltung (CM1, CM2, CM3) enthält, um einen gelesenen elektrischen Zustand nach dem Lesen dieses Zustands zu sichern, um die Abwahl der Bitleitungen (BL) und/oder der Wortleitungen (WL) während dieser Speicherung zuzulassen und um das beim Lesen gelesene Signal anzugeben.

3. Speicher nach einem der Ansprüche 1 oder 2, dadurch gekennzeichnet, daß er eine Schaltung enthält, um die Bitleitungen (BL) im Zeitpunkt der Vorladung und/oder im Zeitpunkt der Abwahl miteinander zu verbinden.

4. Speicher nach einem der Ansprüche 1 bis 3, dadurch gekennzeichnet, daß die Verzögerungsschaltung (R) eine Kaskade von in Serie geschalteten Invertiererschaltungen (6, 7, 8) enthält, wobei zwischen einem mittleren Punkt zwischen zwei Invertierern und einer Referenzspannung eine Kapazität (9, 10) angeschlossen ist.

5. Speicher nach einem der Ansprüche 1 bis 4, dadurch gekennzeichnet, daß die Verzögerungsschaltung (R) ein Zeitintervall bereitstellen kann, das gleich der Taktzeit ist.

6. Speicher nach einem der Ansprüche 1 bis 5, dadurch gekennzeichnet, daß die Verzögerungsschaltung (R) eine Schaltung mit einer Verzögerung enthält, die länger ist als die kalibrierte Verzögerung, um eine Vorladungsschaltung der Leseschaltung auszulösen.
